# EUROPÄISCHE PATENTSCHRIFT

(11) **EP 1 938 167 B1**
(45) Veröffentlichungstag und Bekanntmachung des Hinweises auf die Patenterteilung: **02.06.2010**
(21) Anmeldenummer: 06806191.0
(22) Anmeldetag: 11.10.2006
(51) Int. Cl.: G06F 1/03, H03L 7/18

(54) **SIGNALGENERATOR MIT DIREKT AUSLEITBARER DDS-SIGNALQUELLE**
SIGNAL GENERATOR WITH A DIRECTLY RECOVERABLE DDS SIGNAL SOURCE
GENERATEUR DE SIGNAUX A SOURCE DE SIGNAUX DDS DIRECTEMENT TRANSMISSIBLE

(30) Priorität: 17.10.2005 DE 102005049578
(43) Veröffentlichungstag der Anmeldung: 02.07.2008
(73) Patentinhaber: Rohde & Schwarz GmbH & Co. KG, 81671 München (DE)
(72) Erfinder: RICHT, Bernhard, 81827 München (DE); DANZ, Joachim, 85521 Ottobrunn (DE); KLAGE, Günther, 85604 Zorneding (DE)
(74) Vertreter: Körfer, Thomas
(86) Internationale Anmeldenummer: PCT/EP2006/009828
(87) Internationale Veröffentlichungsnummer: WO 2007/045388

(56) Entgegenhaltungen:
- EP-A- 0 661 815
- US-A- 5 184 092
- US-A- 5 408 687
- US-A1- 2002 094 036

## Beschreibung

Die vorliegende Erfindung betrifft einen Signalgenerator mit DDS-Synthesizer statt Abwärtsmischer.

Moderne Signalgeneratoren werden für eine Vielzahl von Applikationen benötigt. Um für möglichst viele dieser Messapplikationen geeignet zu sein, muß der Signalgenerator über einen sehr großen HF-Frequenzbereich mit hoher Frequenzauflösung verfügen. Heutige erhältliche Signalgeneratoren sind daher mit einem Frequenzbereich von einigen kHz bis zu 6 GHz spezifiziert. Spezielle Mikrowellengeneratoren liefern sogar HF-Signale von typischerweise 10 MHz bis in den Hochfrequenzbereich von bis zu 60 GHz. Diese werden aber in der Regel wegen des höheren Preises nicht für die oben genannten Applikationen eingesetzt.

Man unterscheidet zwei Klassen von Signalgeneratoren. Zum einen gibt es digital modulierbare Signalgeneratoren, die komplexe IQ-modulierte HF-Signale erzeugen, wie sie heute überwiegend in Mobilfunksystemen benutzt werden. Zum anderen gibt es analog modulierbare Signalgeneratoren, die die klassischen analogen Modulationsverfahren wie Frequenz-/Phasenmodulation, Amplitudenmodulation und Pulsmodulation anbieten.

Die Frequenzerzeugung in heutigen Signalgeneratoren erfolgt mit Synthesizern. Zur Erzeugung der erforderlichen hohen Frequenzauflösung des Synthesizers (im Bereich einiger µHz oder noch geringer) kommen zwei Verfahren zum Einsatz. Zum einen das Fraktional-N-Verfahren, bei dem ein Frequenzteiler im Rückwärtspfad einer PLL oder im Referenzpfad vor dem Phasendetektor im Teilungsfaktor dynamisch so variiert wird, dass im zeitlichen Mittel fraktionale Teilungsverhältnisse beliebiger Auflösung entstehen. Das zweite Verfahren ist ein auf dem Prinzip der direkten digitalen Synthese (dem DDS-Prinzip) beruhender Synthesizer, wobei die DDS (direct digital synthesis) entweder das Referenzsignal einer PLL (phase locked loop, geschlossene Phasenregelschleife) erzeugt oder im Rückwärtspfad einer PLL als eine Art fraktionaler Teiler eingesetzt werden kann.

Das HF-Signal des Synthesizers liefern dann spannungsgesteuerte Oszillatoren (VCO), die über eine wie oben beschriebene PLL an die konstante Quarz-Referenz des Generators angebunden sind. Diese decken üblicherweise eine Frequenzoktave, die sog. Grundoktave, ab. Durch anschließende Frequenzteilung, Frequenz-Vervielfachung und -Mischung wird das HF-Ausgangssignal des Signalgenerators in dem geforderten großen Frequenzbereich erzeugt.

Üblicherweise liefern die VCO's HF-Signale in einem Frequenzbereich von z. B. 750 MHz bis 1500 MHz. Durch einfache Frequenzverdopplung entsteht bei diesem Beispiel der Frequenzbereich 1500 MHz bis 3000 MHz, durch eine weitere Verdopplung entsteht der Bereich 3000 MHz bis 6000 MHz. Durch Frequenzteilung durch 2 entsteht der Frequenzbereich 375 MHz bis 750 MHz, bei Teilung durch 4 der Bereich 187,5 MHz bis 375 MHz und so weiter.

Digitale Frequenzteiler haben den Nachteil, dass sie Rechtecksignale an ihrem Ausgang liefern, die anschließend aufwendig tiefpassgefiltert werden müssen, um wieder ein sinusförmiges HF-Ausgangssignal mit geringen Harmonischen zu erhalten. Bei Benutzung von nicht abstimmbaren Tiefpassfiltern werden mindestens zwei solcher Filter pro Oktave benötigt.

Wollte man nun ein sinusförmiges HF-Ausgangssignal mittels Frequenzteilung bis in den kHz-Bereich erzeugen, so wäre ein extrem hoher Aufwand an Teilung und Filterung erforderlich, wodurch hohe Kosten entstünden. In jeder Stufe wäre ein Frequenzteiler und Filter notwendig, der diesen hohen Aufwand bedingt.

Bislang üblich ist es daher den unteren Frequenzbereich mit einem Abwärtsmischer zu generieren. Dazu wird ein höherfrequentes Oszillator-Signal benötigt, das von einer Quarz-Referenz des Signalgenerators abgeleitet wird. Die Ableitung erfolgt über einen Phasenregelkreis, eine phase locked loop. Bei diesem bekannten Verfahren werden Signalfrequenzen auf der Basis einer Oszillatorfrequenz mit Hilfe eines variablen Frequenzteilers und einer Phasendifferenzbildung in einer geschlossenen Regelanordnung erzeugt.

Typische Konstellationen zur Erzeugung des unteren Frequenzbereiches gehen von einer Frequenz der Grundoktave aus. Dabei wird meist auf einen fraktionalen Teiler zurückgegriffen:
LO-Signal : 1000 MHz
Abwärtsmischer-Bereich : 9 kHz bis 100 MHz
HF-Signal des Abwärtsmischers : 1000.009 bis 1100 MHz (in der Grundoktave des Synthesizers enthalten)

So zeigt die Druckschrift US 5,184,092 B1 einen Frequenzgenerator, welcher eine direkte digitale Synthese und eine Phasenregelschleife zur Erzeugung eines Hochfrequenzsignals einsetzt. Die direkte digitale Synthese und die Phasenregelschleife werden dabei in einer geschlossenen Verschaltung eingesetzt. Mittels der Phasenregelschleife wird ein Referenzsignal für die direkte digitale Synthese erzeugt. Einen ähnlichen Stand der Technik zeigt auch die EP 0 661 815 A1.

Die Aufgabe der Erfindung ist es einen Signalgenerator mit einem Synthesizerkonzept zu schaffen, das den Abwärtsmischer zur Erzeugung des unteren Frequenzbereiches nicht mehr erfordert und somit zu einer deutlichen Kostensenkung führt.

Die Aufgabe wird durch die Merkmale des Anspruchs 1 gelöst.

Erfindungsgemäß wird zur Erzeugung eines Teils des Gesamtfrequenzbereiches das Ausgangssignal der DDS-Signalquelle ohne weitere Frequenzteilung oder -mischung direkt an die Pegeleinstellvorrichtung oder den Ausgang des Signalgenerators über eine Direktverbindung geschaltet. Dadurch ist es möglich einen Abwärtsmischer mit gegebenenfalls hochfrequentem Oszillator-Signal zu vermeiden wodurch der Schaltungsaufwand für den Signalgenerator vermindert wird.

Vorteilhafte Weiterbildungen gehen aus den Unteransprüchen hervor.

Dadurch, dass sich der Schaltungsaufwand für den Signalgenerator verringert, verringert sich auch der Platzaufwand der Gesamtschaltung. Die Hardware benötigt weniger Raum wodurch der Signalgenerator insgesamt kompakter hergestellt werden kann. Der mit dem Schaltungsaufwand einhergehende geringere Bauteileaufwand reduziert die Herstellungskosten und die Ausfallwahrscheinlichkeit des Gerätes.

Das Ausgangspektrum des DDS-Signalquelle (auch als DDS-Synthesizer bezeichnet) ist direkt von der Quarz-Referenz abgeleitet und bietet daher sehr gute Phasenrauschwerte. Dieses Ausgangsspektrum kann erfindungsgemäß direkt an die Pegeleinstellvorrichtung oder an den Ausgang weiter gereicht werden, dagegen aber mit dem bisher üblichen Abwärtsmischerkonzept nicht realisiert werden.

Die heutige DDS-Technologie erlaubt Zusatzfunktionen wie die Programmierung des DDS-Kernes. In diesem Zuge lassen sich durch eine digitale Implementierung eine sehr hochwertige Analogmodulation erzielen. Insbesondere lassen sich bei direkter Durchschaltung des Signals der DDS-Signalquelle an den Ausgang die sehr guten Phasenrauscheigenschaften an das Ausgangssignal übertragen.

Ein weiterer Vorteil der Erfindung ist die verringerte Leistungsaufnahme der Gesamtschaltung. Durch Wegfall des Mischer-Verstärkers des lokalen Oszillators und der Mischer-Frequenzerzeugung kann die aufgenommene Leistung reduziert werden wodurch die Auslegung der Netzteile und Zuführungsleitungen geringer ausfallen kann.

Nachfolgend wird ein Ausführungsbeispiel der Erfindung unter Bezugnahme auf die Zeichnung beschrieben. In der Zeichnung zeigen:
- Fig. 1: ein herkömmliches Synthesizerkonzept;
- Fig. 2: ein Synthesizerkonzept gemäß der Erfindung;
- Fig. 3: ein detaillierteres Blockschaltbild des DDS-Kerns mit AM, FM, Pegelsteller und Si-Vorverzerrung.

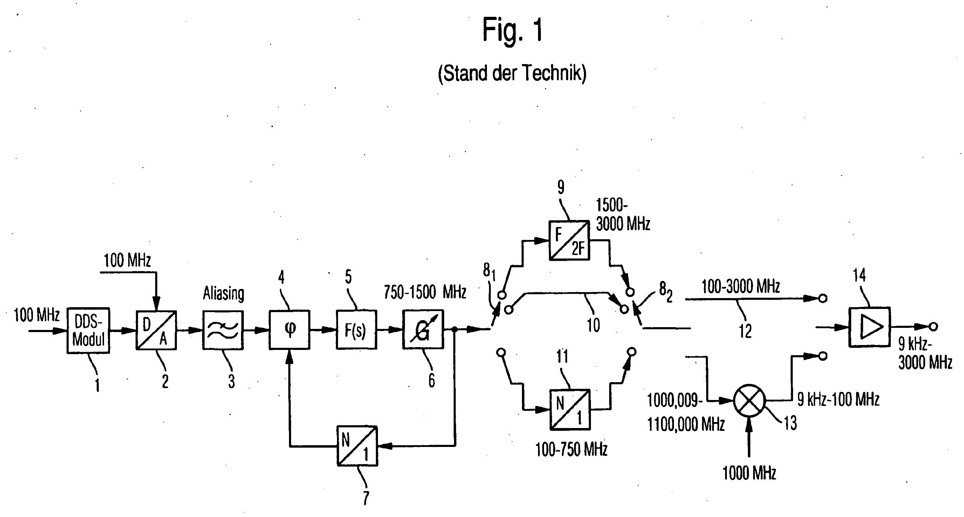

Ein herkömmliches Synthesizerkonzept ist in Fig. 1 dargestellt. Dieses Synthesizerkonzept besteht aus einem DDS Modul 1, einem Digital/Analog Wandler 2, einem Aliasing Filter 3, einer PLL mit einem Phasendetektor 4, einem Filter 5, einem spannungsgesteuerten Oszillator 6, sowie einem variablen Teiler 7.

In der Fig. 1 ist beispielhaft eine Konfiguration des Synthesizers angegeben. Als Taktsignal wird eine Signalfrequenz von 100 MHz eingesetzt. Diese steuert das DDS Modul 1 und den Digital/Analog Wandler 2 an. Das Aliasingfilter 3 empfängt damit am Eingang ein analoges Signal mit einer maximalen Frequenz von 50 MHz. Das Aliasingfilter 3 dient zur Verringerung von Intermodulationen, Rauschen und harmonischen Vielfachen, welche durch Glitches am Ausgang des Digital/Analog Wandlers 2 entstehen.

Dem DDS Modul 1 wird ein Taktsignal zugeführt. Das Taktsignal hat dabei eine Frequenz von beispielsweise 100 MHz. Das Ausgangssignal des DDS Moduls wird in den Digital/Analog Wandler 2 eingespeist. Einem zweiten Eingang des Digital/Analog Wandlers 2 wird ein weiteres Taktsignal zugeführt, essen Frequenz im Ausführungsbeispiel ebenfalls eine Frequenz von 100 MHz aufweist. Das Ausgangssignal des Digital/Analog Wandlers 2 bildet das Eingangssignal für das Filter 3. Das Filter 3 ist ein Aliasingfilter und dient zur Beseitigung von ungewünschten Oberwellen oder Harmonischen der Grundfrequenz. Das gefilterte oder um die Harmonischen der Grundfrequenz bereinigte Ausgangssignal des Filters 3 empfängt schliesslich der Phasendetektor 4 an einem seiner Eingänge.

In der Vorwärtsschleife des Phasenregelkreises befinden sich der Phasendetektor 4, das Filter 5, ein spannungsgesteuerter Oszillator 6 und ein variabler Teiler 7. Zunächst wird das Ausgangssignal des Phasendetektors 4 dem Filter 5 zugeführt. Dieses bildet in dem Phasenregelkreis den Integrator. Diese Ausgangsspannung des Filters 5 bildet in Form einer Treppenfunktion das Eingangssignal des spannungsgesteuerten Oszillators 6. Je nach Vorgabespannung wird so die Ausgangsfrequenz des spannungsgesteuerten Oszillators 6 den Erfordernissen der Frequenzvorgabe angepasst.

Das Ausgangssignal des spannungsgesteuerten Oszillators 6 bildet zum einen das Ausgangssignal des geschlossenen Phasenregelkreises und zum anderen im Rückwärtspfad der geschlossenen Schleife das Vergleichssignal zur Vorgabe. Der Frequenzteiler 7 teilt die Frequenz des Eingangssignals und führt dieses dem Phasendetektor 4 zu.

In der geschlossenen Regelschleife wird das Ausgangssignal des Frequenzteilers 7 dem Phasendetektor 4 zugeführt. Auf der Basis des Phasenvergleichs des Ausgangssignals des Frequenzteilers 7 und des gefilterten Signals aus dem Filter 3 erzeugt der Phasendetektor 4 ein Vergleichssignal.

Im Anschluß an die PLL folgt im in Fig. 1 dargestellten Blockschaltbild eine Anordnung, um das Ausgangssignal entweder zu verdoppeln, zu teilen oder direkt an nachfolgende Stufen weiterzuverbinden.

Das Ausgangssignal des spannungsgesteuerten Oszillators 6 kann über einen Wahlschalter 8₁ dem Frequenzverdoppler 9, über einen Direktverbinder 10 dem Wahlschalter 8₂ oder dem variablen Frequenzteiler 11 zugeführt werden. Das vom Wahlschalter 8₂ wegführende Signal kann über einen Direktverbinder 12 oder über den Mischer 13 der Pegeleinstellvorrichtung 14 zugeführt werden.

Die dargestellte PLL Schaltung stellt im Ausführungsbeispiel am Ausgang Signale mit einer Frequenz von 750 MHz bis 1500 MHz bereit. Wie oben erwähnt, kann die Frequenz dieser Signale entweder weiter erhöht oder entsprechend weiter verringert werden. In der gegebenen Konfiguration wird eine Frequenzverdopplung oder -teilung durchgeführt, so dass Signale im Bereich von 100 MHz bis 3000 MHz erzeugt werden können.

Durch den Abwärtsmischer können desweiteren Signale der Frequenzen 1000,009 bis 1100,000 MHz erzeugt werden. Das Eingangssignal wird um eine Frequenz von 1000 MHz reduziert und damit in den Frequenzbereich von 9 kHz bis 100 MHz gemischt, womit der Gesamtfrequenzbereich von 100 MHz bis 3000 MHz auf 9 kHz bis 3000 MHz erweitert wird.

Das dem Mischer 13 zugeführte Signal - in dem Ausführungsbeispiel umfasst das Signal Frequenzen zwischen 1000,009 MHz und 1100,000 MHz - wird mit einem Signal gemischt, das dem Mischer an einem zweiten Eingang zugeführt wird. Der Mischer 13 stellt einen Abwärtsmischer dar mit dem ein Eingangssignal herunter gemischt werden kann. Das Eingangssignal in der Schaltung kann entweder von dem Frequenzverdoppler 9, dem Frequenzteiler 11 oder direkt von der PLL, dem Phasenregelkreis, stammen. In dem Ausführungsbeispiel hat das zugeführte Referenz- oder Mischsignal eine Frequenz von 1000.000 MHz. Am Ausgang des Mischers 13 sind damit Frequenzen zwischen 9 kHz und 100 MHz verfügbar.

Das Ausgangssignal der Pegeleinstellvorrichtung 14 ist das Ausgangssignal des Signalgenerators. In dem Ausführungsbeispiel umfasst das Ausgangssignal somit Frequenzen im Frequenzbereich zwischen 9 kHz und 3000 MHz. Bei der Pegeleinstellvorrichtung handelt es sich um einen hinsichtlich des Verstärkungsfaktors einstellbaren Verstärker oder ein hinsichtlich des Dämpfungsfaktors einstellbares Dämpfungselement.

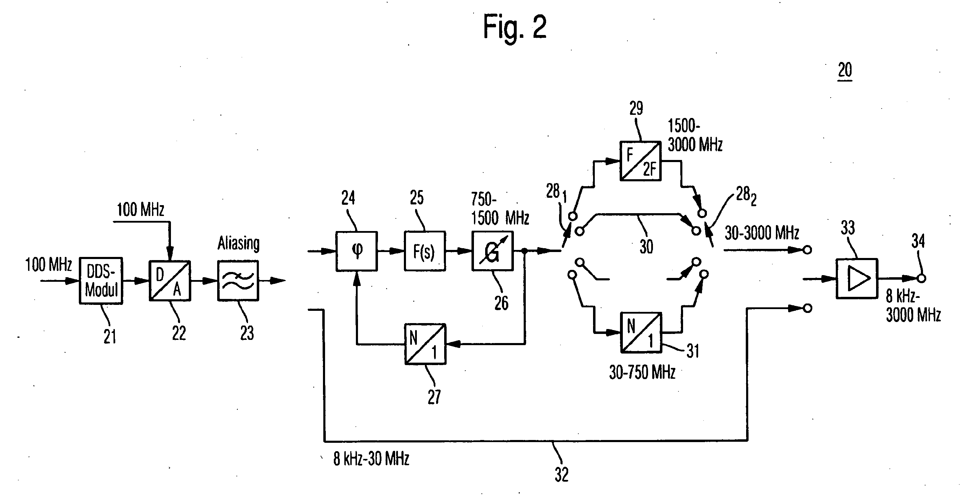

Ein verändertes Synthesizerkonzept 20 gemäß der Erfindung ist in Fig. 2 dargestellt. Dieses besteht im wesentlichen aus den gleichen Komponenten wie die Schaltung in Fig. 1.

Diese sind ein DDS-Modul 21, ein D/A-Wandler 22, ein Aliasingfilter 23, eine PLL mit dem Phasendetektor 24, ein Filter 25, ein spannungsgesteuerter Oszillator 26 und ein Frequenzteiler 27, ein Frequenzverdoppler 28, ein variabler Frequenzteiler 29, eine Durchverbindung 30, und eine Pegeleinstellvorrichtung 33.

Dem DDS-Modul 21 wird ein Taktsignal zugeführt, wobei das Taktsignal auch in diesem Beispiel eine Frequenz von 100 MHz hat. Das Ausgangssignal des DDS-Moduls wird in einen Digital/Analog Wandler 22 eingespeist. Einem zweiten Eingang des Digital/Analog Wandlers 22 wird ein weiteres Taktsignal zugeführt, dessen Frequenz im Beispiel ebenfalls eine Frequenz von 100 MHz besitzt. Das Ausgangssignal des Digital/Analog Wandlers 22 bildet das Eingangssignal für den Filter 23. Das Filter 23 ist auch hier ein Aliasingfilter. Das gefilterte oder um die Harmonischen der Grundfrequenz bereinigte Ausgangssignal des Filters 23 empfängt schliesslich der Phasendetektor 24 an einem seiner Eingänge.

In der erfindungsgemäßen Ausführungsform ist etwa die gleiche Frequenzkonfiguration des Synthesizers wie in Fig. 1 angegeben. Als Taktsignal wird im Beispiel eine Frequenz von 100 MHz eingesetzt. Diese steuert das DDS Modul 21 und den Digital-Analog-Wandler 22 an. Damit empfängt das Aliasingfilter 23 am Eingang ein analoges Signal mit einer maximalen Frequenz von 50 MHz.

Ähnlich wie in der Schaltung in Fig. 1 liefern die drei Komponenten DDS Modul 21, Digital/Analog Wandler 22, und Aliasingfilter 23 das Vorgabesignal für den Phasenregelkreis 24,25,26,27 aber erfindungsgemäß auch zugleich das Direktsignal für den unteren Frequenzbereich des Signalgenerators 20.

In der Vorwärtsschleife des Phasenregelkreises befinden sich auch hier ein Phasendetektor 24, das Filter 25, ein spannungsgesteuerter Oszillator 26 und ein variabler Teiler 27. Zunächst wird das Ausgangssignal des Phasendetektors 24 dem Filter 25 zugeführt. Dieser bildet in dem Phasenregelkreis den Integrator. Dessen Ausgangsspannung bildet in Form einer Treppenfunktion das Eingangssignal des spannungsgesteuerten Oszillators 26. Je nach Vorgabespannung wird so die Ausgangsfrequenz des spannungsgesteuerten Oszillators 26 der Frequenzvorgabe angepasst.

Der Phasenregelkreis 24,25,26,27 besteht aus dem Phasendetektor 24, dem Filter 25, dem spannungsgesteuerten Oszillator 26 und dem variablen Frequenzteiler 27.

Im Rückwärtspfad des Regelkreises befindet sich der variable Frequenzteiler 27 über den die Ausgangssignalfrequenz des Phasenregelkreises bestimmt wird. Dessen Ausgangssignal wird am zweiten Eingang des Phasendetektors 24 eingespeist und mit der Vorgabe aus dem Aliasingfilter 23 verglichen.

Im Anschluß an den Phasenregelkreis folgt auch hier vorzugsweise eine Anordnung das Ausgangssignal entweder zu verdoppeln, zu teilen oder direkt an nachfolgende Stufen weiterzuverbinden. Bezüglich der Funktion der Elemente 28₁, 28₂, 29, 30, 31 und 33 kann auf Fig. 1 verwiesen werden, wobei diese Elemente den derartigen Elementen 9, 10, 11 und 14 entsprechen.

Die dargestellte PLL Schaltung stellt, wie auch im Stand der Technik, am Ausgang Signale mit einer Frequenz von 750 MHz bis 1500 MHz bereit. Die Frequenz dieser Signale kann entweder weiter erhöht oder verringert werden. In der gegebenen Konfiguration wird eine Frequenzverdopplung oder -teilung durchgeführt, so dass Signale im Bereich von 30 MHz bis 3000 MHz erzeugt werden können.

Im Gegensatz zu der Schaltung in Fig. 1 kann in dieser Schaltung erfindungsgemäß das Ausgangssignal des DDS-Moduls nach einer D/A-Wandlung mit dem D/A-Wandler 22 und Filterung mit dem Filter 23 direkt über die Verbindung 32 an den Ausgang gegeben werden.

Die Schaltung stellt Signale in einem Frequenzbereich von 8 kHz bis 3000 MHz bereit. Der untere Frequenzbereich von 8 kHz bis 30 MHz wird direkt vom Ausgang des Aliasingfilters 23 an den Ausgang der des Signalgenerators 20 über die Direktverbindung 32 geleitet. Der Frequenzbereich von 30 bis 3000 MHz wird durch die PLL, Frequenzteilung und -verdopplung erzeugt.

Da in der erfindungsgemäßen Ausführung der untere Frequenzbereich durch eine Direktverbindung 32 an eine Pegeleinstellvorrichtung 33 übertragen wird, wird der Abwärtsmischer 13 nicht mehr benötigt.

Das komplizierte und mit hohem Aufwand verbundene Abwärtsmischen wird vermieden. Die Signale mit den Frequenzen 1000,009 bis 1030,000 MHz müssen nicht erst erzeugt und dann herunter gemischt werden. Das Eingangssignal einer relativ hohen Frequenz mit fraktionalem Anteil muß bei der erfindungsgemäßen Ausführung nicht um eine Frequenz von 1000 MHz reduziert und damit in den unteren Frequenzbereich von 8 kHz bis 30 MHz gemischt werden. Der Gesamtfrequenzbereich wird so von 30 MHz bis 3000 MHz auf 8 kHz bis 3000 MHz ohne Abwärtsmischer erweitert.

Das Abwärtsmischsignal von beispielsweise 1000 MHz in Fig. 1 muss beim Stand der Technik bereitgestellt und dem Abwärtsmischer zugeführt werden. Die Erzeugung des Abwärtsmischsignals ist, wenn es nicht direkt von der Taktfrequenz abgeleitet werden kann, an die Bereitstellung mit einem weiteren Phasenregelkreis gekoppelt.

Das Ausgangssignal der Pegeleinstellvorrichtung 33 ist das Ausgangssignal des Signalgenerators 20. In dem Ausführungsbeispiel umfasst das Ausgangssignal Frequenzen im Frequenzbereich zwischen 8 kHz und 3000 MHz.

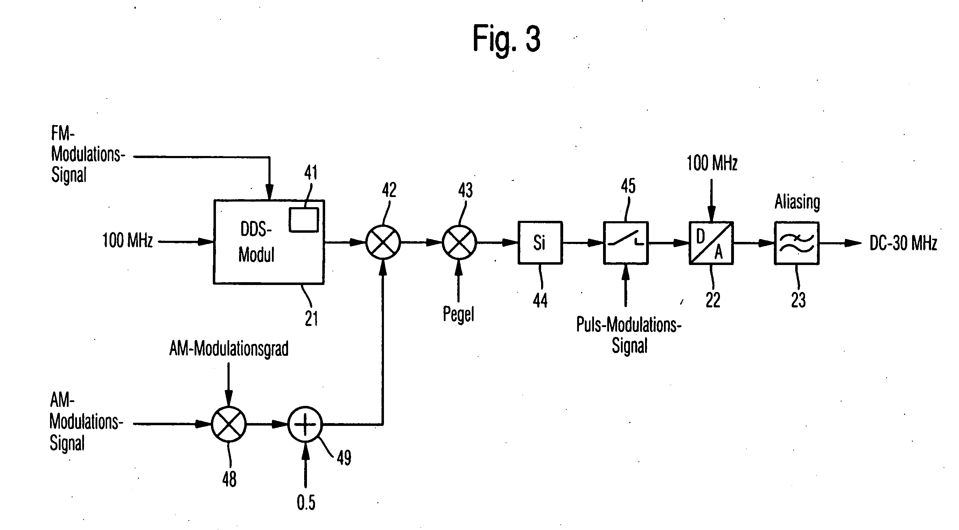

Ein modifiziertes Blockschaltbild zur Bereitstellung modulierter Signale ist in Fig. 3 als zweites Ausführungsbeispiel gezeigt. Ein DDS Modul 21 erzeugt digitale, frequenzmodulierte oder phasenmodulierte Signale. Die Vorgabe erfolgt durch einen gesonderten Eingang, der die zeitabhängige Änderung des Modulationswortes repräsentiert. Das digitale FM-Signal, welches am Ausgang des DDS-Moduls bereitsteht kann zusätzlich noch amplitudenmoduliert werden. Dazu dienen ein AM-Modulations-Signaleingang, die Vorgabe eines AM-Modulationsgrades und die Addition eines zusätzlichen Offsetwertes von 0,5.

Das AM/FM Signal kann dann noch in seinem Pegel modifiziert, in einer Si-Vorverzerrung frequenzgangkorrigiert, sowie pulsmoduliert werden. Bevor das analoge Signal am Ausgang bereitgestellt wird, wird das digitale Signal über einen D/A-Wandler 22 in ein analoges Signal gewandelt und einem Aliasing-Filter 23 zugeführt.

In der dargestellten Konfiguration wird das DDS-Modul 21 mit einer Takt- oder Grundfrequenz von 100 MHz betrieben.

Am Ausgang stehen FM-Signale oder PM-Signale bis zu einer Frequenz von 30 MHz bereit.

Ein FM-Modulationssignal kann das DDS-Modul 21 direkt ansteuern. Dieses wird an einem zweiten Eingang wieder mit dem Taktsignal versorgt. Im Ausführungsbeispiel ist auch hier eine Taktfrequenz von 100 MHz vorgesehen. Diese DDS-Signalquelle verfügt über eines oder mehrere sogenannte Phasen- oder Frequenzregister 41₁, in welche das Modulationswort eingeschrieben wird. Das Ausgangssignal der DDS-Signalquelle 41 wird einem Mischer 42 zugeführt.

Das AM-Modulationssignal wird einem Mischer 48 zugeführt. Der AM-Modulationsgrad wird dem gleichen Mischer 48 zugeführt. Das Ausgangssignal des Mischers 48 wird einem Addierer 49 zugeführt. Ein konstanter Wert von beispielsweise 0,5 wird ebenfalls dem Addierer 49 zugeführt. Das Ausgangssignal des Addierers 49 wird dem Mischer 42 zugeführt.

Das kombinierte Signal aus dem Mischer 42 wird dem Mischer 43 zugeführt. Ausserdem wird dem Mischer 43 ein Pegel zugeführt und damit das Signal mit einem Pegel beaufschlagt. Das Ausgangssignal des Mischers 43 wird einer Si-Vorverzerrungseinheit 44 zugeführt und dabei frequenzgangkorrigiert. Das Signal kann noch in einer Pulsmodulationseinheit 45 pulsmoduliert werden. Dazu wird an einem zweiten Eingang der Pulsmodulationseinheit 45 ein Puls-Modulationssignal zugeführt. Das Ausgangssignal der Pulsmodulationseinheit 45 wird dem Digital/Analog Wandler 22 zugeführt.

Die Erfindung ist nicht auf die beschriebenen Ausführungsbeispiele beschränkt. Der erfindungsgemäße Signalgenerator kann vielfältig zum Einsatz kommen. Alle beschriebenen und gezeichneten Elemente sind beliebig miteinander kombinierbar.

## Patentansprüche

1. Signalgenerator (20) mit einer DDS-Signalquelle (21), die nach dem Prinzip der direkten digitalen Synthese, DDS, arbeitet, sowie einem PLL-Signalsynthesizer (24,25,26,27), der nach dem Prinzip der geschlossenen Phasenregelschleife, PLL, unter Verwendung des Signals der Signalquelle (21) als Referenzsignal arbeitet,
wobei zur Erzeugung eines Teils des Gesamtfrequenzbereiches des Ausgangssignals des Signalgenerators (20) die DDS-Signalquelle (21) ohne weitere Frequenzteilung oder Mischung direkt an den Ausgang (34) oder eine Pegeleinstellvorrichtung (33) des Signalgenerators (20) über eine Direktverbindung (32) schaltbar ist,
**dadurch gekennzeichnet,**
**dass** in einem unteren Teil des Gesamtfrequenzbereiches das Ausgangssignal der DDS-Signalquelle (21) ohne weitere Frequenzteilung oder Mischung direkt an den Ausgang (34) oder die Pegeleinstellvorrichtung (33) des Signalgenerators (20) schaltbar ist, und
**dass** im übrigen Teil des Gesamtfrequenzbereichs das Signal des PLL-Signalsynthesizers an den Ausgang des Signalgenerators (20) schaltbar ist.

2. Signalgenerator gemäß Anspruch 1,
**dadurch gekennzeichnet,**
**dass** dem PLL-Signalsynthesizer (24,25,26,27) ein Frequenzverdoppler (29) und/oder Frequenzteiler (31) nachgeschaltet ist.

3. Signalgenerator gemäß Anspruch 1 oder 2,
**dadurch gekennzeichnet,**
**dass** die Amplitude des Ausgangssignals des Signalgenerators (20) durch digitale Pegelsteller (42,43,48) in der DDS-Signalquelle (21) fein einstellbar ist.

4. Signalgenerator gemäß einem der Ansprüche 1 bis 3,
**dadurch gekennzeichnet,**
**dass** in der DDS-Signalquelle (21) ein Frequenz- und/oder Phasenregister (41) vorhanden sind, wobei eine Frequenz- oder Phasenmodulation durch Addition eines Modulationswortes in das Frequenz- bzw. Phasenregistern (41) der DDS-Signalquelle (21) durchgeführt wird.

5. Signalgenerator gemäß einem der Ansprüche 1 bis 4,
**dadurch gekennzeichnet,**
**dass** ein Multiplizierer (42) vorhanden ist in welchem eine Amplituden- oder Pulsmodulation durch Multiplizieren des digitalen Ausgangswortes der DDS-Signalquelle (21) mit einem digitalen Modulationswort erzeugt wird.

## Claims

1. A signal generator (20) with a DDS signal source (21), which operates according to the principle of direct digital synthesis DDS, and a PLL signal synthesiser (24, 25, 26, 27), which operates according to the principle of the phase locked loop PLL, using the signal of the signal source (21) as a reference signal,
wherein, for the generation of a part of the total frequency range of the output signal of the signal generator (20) the DDS signal source (21) can be connected without further frequency division or mixing directly to the output (34) or a level adjustment device (33) of the signal generator (20) via a direct connection (32),
**characterised in that**,
in a lower part of the total frequency range, the output signal of the DDS signal source (21) can be connected without further frequency division or mixing directly to the output (34) or the level adjustment device (33) of the signal generator (20), and
that in the other part of the total frequency range, the signal of the PLL signal synthesiser can be connected to the output of the signal generator (20).

2. The signal generator according to claim 1,
**characterised in that**
a frequency doubler (29) and/or frequency divider (31) is connected downstream of the PLL signal synthesiser (24, 25, 26, 27).

3. The signal generator according to claim 1 or 2,
**characterised in that**
the amplitude of the output signal of the signal generator (20) can be fine tuned through digital level adjusters (42, 43, 48) in the DDS signal source (21).

4. The signal generator according to any one of claims 1 to 3,
**characterised in that**
a frequency and/or phase register (41) are present in the DDS signal source (21), wherein a frequency or phase modulation is implemented through addition of a modulation word to the frequency and/or phase registers (41) of the DDS signal source (21).

5. The signal generator according to any one of claims 1 to 4,
**characterised in that**
a multiplier (42) is present, in which an amplitude or pulse modulation is generated by multiplying the digital output word of the DDS signal source (21) with the digital modulation word.

## Revendications

1. Générateur de signaux (20) comportant une source de signaux DDS (21), qui fonctionne selon le principe de la synthèse numérique directe, DDS, ainsi qu'un synthétiseur de signaux PLL (24, 25, 26, 27), qui fonctionne selon le principe de la boucle à verrouillage de phase, PLL, en utilisant le signal de la source de signaux (21) en tant que le signal de référence,
dans lequel, en vue de la génération d'une partie de la zone de fréquence globale du signal de sortie du générateur de signaux (20), la source de signaux DDS (21) peut être commutée sans autre division de fréquence ou mélange directement à la sortie (34) ou à un dispositif de réglage de niveau (33) du générateur de signaux (20) par l'intermédiaire d'une liaison directe (32),
**caractérisé en ce que**
dans une partie inférieure de la zone de fréquence globale, le signal de sortie de la source de signaux DDS (21) peut être commuté sans autre division de fréquence ou mélange directement à la sortie (34) ou au dispositif de réglage de niveau (33) du générateur de signaux (20), et
**en ce que**, dans une autre partie de la zone de fréquence globale, le signal du synthétiseur de signaux PLL peut être commuté à la sortie du générateur de signaux (20).

2. Générateur de signaux selon la revendication 1,
**caractérisé en ce que**
un doubleur de fréquence (29) et/ou un diviseur de fréquence (31) est monté en aval d'un synthétiseur de signaux PLL (24, 25, 26, 27).

3. Générateur de signaux selon la revendication 1 ou 2,
**caractérisé en ce que**
l'amplitude du signal de sortie du générateur de signaux (20) peut être réglée de façon fine grâce à un régulateur de niveau numérique (42,43,48) dans la source de signaux DDS (21).

4. Générateur de signaux selon l'une des revendications 1 à 3,
**caractérisé en ce que**
dans la source de signaux DDS (21) est prévu un registre de fréquence et/ou de phase (41), dans lequel une modulation de fréquence ou une modulation de phase est effectuée par addition d'un mot de modulation dans les registres de fréquence ou de phase (41) de la source de signaux DDS (21).

5. Générateur de signaux selon l'une des revendications 1 à 4,
**caractérisé en ce que**
un multiplicateur (42) est prévu, dans lequel une modulation d'amplitude ou d'impulsion est générée par multiplication du mot de sortie numérique de la source de signaux DDS (21) par un mot de modulation numérique.
